# EUROPÄISCHE PATENTSCHRIFT

(11) **EP 1 764 856 B1**
(45) Veröffentlichungstag und Bekanntmachung des Hinweises auf die Patenterteilung: **18.03.2020**
(21) Anmeldenummer: 06018305.0
(22) Anmeldetag: 01.09.2006
(51) Int. Cl.: H01M 10/42, H01M 10/48

(54) **Verfahren**
Method
Méthode

(30) Priorität: 20.09.2005 DE 102005045700
(43) Veröffentlichungstag der Anmeldung: 21.03.2007
(73) Patentinhaber: Metabowerke GmbH, 72622 Nürtingen (DE)
(72) Erfinder: Wiesner, Bernd, Dipl.-Ing., 73277 Owen (DE); Gräber, Jochen, 73266 Bissingen (DE)
(74) Vertreter: Raunecker, Klaus Peter

(56) Entgegenhaltungen:
- WO-A-2004/030177
- JP-A- 9 171 065
- JP-A- 2005 106 504
- JP-A- 2005 117 765
- US-A- 6 020 718
- US-A- 6 144 189

## Beschreibung

Die Erfindung betrifft ein Verfahren zur Bestimmung der Spannung der Akkuzellen. Die Dokumente US6144189, WO2004/030177, US6020718, JP9171065, JP2005117765, JP2005106504 offenbaren verschiedene Multiplexanordnungen.

Dabei ist es bisher im Stand der Technik bekannt, die Spannung hinter den einzelnen in Reihe geschalteten Akkuzellen abzugreifen, indem jeweils jede Akkuzelle mit einer Messanordnung umfassend einen Messverstärker und/oder Analog-Digital-Wandler verbunden ist.

Derartige Abgriffe der Spannungen der einzelnen Zellen sind notwendig, um diese mittels einer elektronischen Überwachungsschaltung hinsichtlich ihres Ladezustands zu überwachen. Erfolgt keine Ladezustandsüberwachung und im Zweifelsfall eine Regelung des Ladestroms zu den einzelnen Zellen, kann es auf der einen Seite zu einer Zerstörung einzelner Zellen aufgrund eines beispielsweise zu hohen Ladestroms kommen, auf der anderen Seite kann jedoch auch der Fall eintreten, dass einzelne Zellen in der Reihe nicht mehr vollständig aufgeladen werden. Darüber hinaus kann auch nicht festgestellt werden, wenn einzelne Zellen aufgrund eines Fehlers nicht mehr mit aufgeladen werden. Hier sind insbesondere die in letzter Zeit aufgrund ihrer hohen Leistungsfähigkeit vielfach eingesetzten Lithiumionenakkuzellen empfindlich.

Es ist daher in jedem Fall notwendig, die Aufladung der einzelnen Zellen in einem Ladegerät bestimmen zu können. Eine derartige Ausgestaltung ist jedoch nachteilig, da sie verhältnismäßig aufwendig ist und die verwendeten Bauteile eine Kostenerhöhung bei der Herstellung eines entsprechenden Akkupacks bedingen.

Es ist daher nun Aufgabe der Erfindung, ein Verfahren zum Bestimmen von Spannungen einzelner in Reihe angeordneter Akkuzellen bereitzustellen.

Die Erfindung löst diese Aufgabe durch die Vorsehung einer Multiplexanordnung im Akkupack zwischen den Akkuzellen und der Elektronikeinheit, wobei die Spannungswerte der Akkuzellen zyklisch nacheinander abgegriffen und die erhaltenen Werte durch die Multiplexanordnung an die Elektronikeinheit abgegeben werden. Die Elektronikeinheit kann über eine einzige Messanordnung jeweils die Spannung der gerade gemessenen Zelle ermitteln. Auf diese Weise kann vorgesehen sein, dass lediglich ein einzelner Messverstärker und/oder A/D-Wandler vorgesehen sein muss. In diesem Fall kann dann ein messgenauerer Verstärker verwendet werden, so dass bei gesenkten Kosten eine erheblich genauere Bestimmung der Spannung möglich ist.

Bei den Akkuzellen kann es sich insbesondere um Lithiumzellen handeln. Dabei besitzen Lithiumakkus den Vorteil, eine vergleichsweise hohe Energiedichte bereitzustellen und sind somit besonders geeignet, tragbare Elektrohandwerkzeuge, die auf der einen Seite ein möglichst geringes Gewicht und damit eine gute Handhabbarkeit besitzen sollen, auf der anderen Seite jedoch auch eine hohe Leistung gewährleisten müssen, mit Energie zu versorgen. Allerdings besitzen Lithiumionenzellen den Nachteil, dass diese bei einer Tiefentladung insbesondere unter 2 V nicht mehr brauchbar sind. Auf der anderen Seite kann jedoch auch eine Überladung die Zellen schädigen und im Extremfall zu einer Explosion der Zellen führen. Eine genaue Ladezustandsbestimmung ist daher bei dieser Technik besonders wichtig.

Darüber hinaus kann vorgesehen sein, dass die Spannung jeder einzelnen Akkuzelle abgegriffen wird, oder, sofern parallelgeschaltete Akkuzellen, sogenannte Akkublöcke vorgesehen sind, die Spannung jedes einzelnen Akkublocks abgegriffen wird.

Die Erfindung betrifft ein Verfahren zum Bestimmen von Spannungen einzelner in Reihe angeordneter Akkuzellen in einem Akkupack der vorstehenden Art, wobei zyklisch nacheinander zunächst das Potential vor jeder in Reihe geschalteter Akkuzelle und anschließend nach der letzten Akkuzelle bestimmt wird, die Potentialwerte über eine Multiplexanordnung an eine Elektronikeinheit weitergeleitet werden und in der Elektronikeinheit zur Bestimmung des Ladezustands die Spannungszustände der einzelnen Akkuzellen oder Akkublöcke ermittelt werden.

Es wird hierbei zunächst das Potential gegenüber der Masse bestimmt, wie es vor der ersten der in Reihe geschalteten Akkuzellen anliegt. Danach wird vor jeder weiteren der Zellen und damit auch zugleich nach jeder der Zellen das Potential bestimmt. Auf diese Weise wird dann in einer Auswerteeinheit, nämlich der Elektronikeinheit, die Spannung über die einzelnen Zellen ermittelt. Auf diese Weise kann ein Ladezustand bestimmt werden und es kann gegebenenfalls eine Regelung der weiteren Aufladung erfolgen, um eine Überladung einzelner Zellen zu verhindern. Darüber hinaus kann hierüber auch verhindert werden, dass einzelne Zellen unter einen minimalen Spannungswert absinken.

Es kann dabei vorgesehen sein, dass das Verfahren kontinuierlich durchgeführt wird, insbesondere sofern die Zellen sich im Aufladevorgang befinden. Alternativ ist es jedoch auch möglich, dass das Verfahren lediglich zu einzelnen diskreten Zeitpunkten abläuft.

Darüber hinaus kann auch vorgesehen sein, dass das Verfahren auch während des Betriebs des Akkupacks beispielsweise in einem Elektrohandwerkzeuggerät abgefragt wird. Auf diese Weise kann die Spannung und damit auch der Ladezustand und somit die verbleibende Arbeitszeit ermittelt werden. Hierüber ist es dann möglich, eine Ladezustandsanzeige, die an einem entsprechenden Akkupack oder auch an einem entsprechenden Elektrohandwerkzeuggerät vorgesehen sein kann, mit den angegebenen Werten zu versorgen, so dass dann eine Anzeige für den Bediener erfolgen kann, dergestalt dass beispielsweise angezeigt wird, dass der Akkupack noch eine Akkuleistung von 25%, 50%, 75% oder 100% hat. Auch eine kontinuierliche Anzeige ist denkbar. Weitere Anzeigemöglichkeiten sind ein akustisches Signal, dass anzeigt, dass nur noch eine gewisse Restarbeitsdauer verblieben ist.

Weitere Vorteile und Merkmale ergeben sich aus den übrigen Anmeldungsunterlagen.

Die Erfindung soll im Folgenden anhand eines Beispiels näher erläutert werden. Dabei soll ein Elektrohandwerkzeuggerät, nämlich eine Schlagbohrmaschine, als tragbares Akkugerät ausgestaltet sein. Der Akkupack, der ein Akkugehäuse aufweist, kann mit dem Elektrohandwerkzeuggerät sowohl mechanisch als auch elektrisch verrastet und kontaktiert werden. In dem Akkupack sind acht Akkuzellen angeordnet, wobei jeweils zwei Akkuzellen parallel geschaltet sind. Eine derartige Parallelschaltung ist vorzugsweise bei Lithiumionenzellen vorgesehen, im Gegensatz beispielsweise zu Nickel-Cadmium-Akkus. Diese Zusammenschaltung von zwei Akkuzellen wird als Akkuzellenblock bezeichnet. Vier dieser Akkuzellenblöcke sind in einer Reihenschaltung angeordnet. Von jedem der Akkuzellenblöcke geht nun eine elektrische Verbindung zur Elektronik des Akkupacks. Die Elektronik einschließlich der Leiterplatte kann dabei in ein Elektronikgehäuse aufgenommen sein und dort insbesondere materialschlüssig beispielsweise durch Eingießen festgelegt werden.

Des Weiteren umfasst die Elektronik einen Multiplexer, über den sämtliche Elektronik-Eingänge der Akkuzellenblöcke geführt sind. Der Multiplexer ist wiederum mit einer Messwertaufbereitungseinrichtung in der Elektronik verbunden.

Während des Betriebs aber auch des Aufladevorgangs des Akkupacks wird nun kontinuierlich das Potential zunächst vor dem ersten Akkuzellenblock gegenüber dem Massepotential bestimmt. Dieses Potential wird als Vergleichspotential festgelegt. Danach erfolgt zeitlich versetzt hierzu eine Bestimmung des Potentials nach dem ersten Akkuzellenblock, wobei aus der Differenz dann die Spannung über den ersten Akkuzellenblock bestimmt werden kann. Zeitlich versetzt hierzu wird dann das Potential nach dem zweiten Akkuzellenblock, danach nach dem dritten Akkuzellenblock sowie danach nach dem vierten Akkuzellenblock bestimmt. Das Schalten von einem Akkuzellenblock zum nächsten übernimmt der Multiplexer. Durch Differenzbildung jeweils mit der Spannung des davor liegenden Blocks kann die jeweilige Spannung über den einzelnen Akkuzellenblock bestimmt werden. Ausgehend von den hieraus ermittelten Daten, die mittels eines Messverstärkers aufbereitet werden, der besonders messgenau sein kann, können die verschiedenen Ladungszustände beim Be- und Entladen des Akkupacks ermittelt werden.

Mit diesen Daten kann eine Ladezustandsanzeige betrieben werden, die beispielsweise beim Gebrauch des Elektrohandwerkzeuggeräts den aktuellen Ladezustand anzeigt. Die Anzeige erfolgt über ein optisches Signal. Darüber hinaus kann auch bei der Beladung des Akkupacks über die Bestimmung des Ladezustands der einzelnen Akkuzellenblöcke die Aufladung so geregelt werden, dass alle Akkuzellenblöcke optimal und maximal aufgeladen werden, es jedoch nicht zu einer Überladung einzelner Akkuzellenblöcke kommt. Eine entsprechende Regelung kann beispielsweise über den Ladestrom erfolgen.

Auf die vorstehend beschriebene Weise kann besonders einfach und kostengünstig eine genaue Bestimmung der Ladezustände der einzelnen Akkuzellen erfolgen.

## Patentansprüche

1. Verfahren zum Bestimmen von Spannungen einzelner Akkuzellen in einem Ackupack eines Elektrohandwerkzeuggerätes, welches ein Akkugehäuse sowie in dem Akkugehäuse angeordnete in Reihe geschaltete Akkuzellen und eine mit den Akkuzellen verbundene Elektronikeinheit zur Bestimmung der Spannung der Akkuzellen umfasst,
wobei eine Multiplexanordnung zwischen den Akkuzellen und der Elektronikeinheit vorgesehen ist, die Spannungswerte der Akkuzellen kontinuierlich oder zu diskreten Zeitpunkten während des Auflade- und Entladevorgangs zyklisch nacheinander abgreift und die erhaltenen Werte dann an die Elektronikeinheit abgibt,
wobei die Spannung jeder einzelner Akkuzelle oder eines aus parallelgeschalteten Akkuzellen bestehenden Akkuzellenblocks separat abgreifbar ist und wobei eine den Ladezustand des Akkupacks anzeigende Ladezustandsanzeige vorgesehen ist,
wobei kontinuierlich oder zu diskreten Zeitpunkten während des Auflade- und Entladevorganges zyklisch nacheinander zunächst das Potential vor jeder in Reihe geschalteten Akkuzelle und anschließend nach der letzten Akkuzelle bestimmt wird, die Potentialwerte über die Multiplexanordnung an die Elektronikeinheit weitergeleitet werden, in der Elektronikeinheit zur Bestimmung des Ladezustands die Spannungszustände der einzelnen Akkuzellen ermittelt werden, wobei die Ermittlung der Spannung einer einzelnen Akkuzelle durch Differenzbildung des Potentials nach der jeweiligen Akkuzelle und des Potentials vor der jeweiligen Akkuzelle erfolgt, und der Ladezustand angezeigt wird.

2. Verfahren nach Anspruch 1, wobei die Ladezustandsanzeige ein optisches oder akustisches Signal umfasst.

3. Verfahren nach Anspruch 1 oder 2, wobei der Multiplexanordnung nachgeschaltet eine Messwertaufbereitungseinrichtung vorgesehen ist.

4. Verfahren nach Anspruch 3, wobei die Messwertaufbereitungseinrichtung einen Analog/Digital-Wandler und/oder einen Messverstärker umfasst.

5. Verfahren nach einem der vorangehenden Ansprüche, wobei die Akkuzellen Lithiumzellen sind.

## Claims

1. Method for determining voltages of individual battery cells in a battery pack of an electric hand tool, which comprises a battery housing as well as series-connected battery cells arranged in the battery housing and an electronic unit connected to the battery cells for determining the voltage of the battery cells
wherein a multiplex arrangement is provided between the battery cells and the electronic unit, the voltage values of the battery cells are tapped continuously or at discrete times during the charging and discharging process cyclically one after the other and the values obtained are then transmitted to the electronic unit,
wherein the voltage of each individual battery cell or of a battery cell block consisting of battery cells connected in parallel can be tapped off separately and wherein a state of charge display indicating the state of charge of the battery pack is provided,
wherein continuously or at discrete points in time during the charging and discharging process the potential before each series-connected battery cell and then after the last battery cell is determined cyclically one after the other, the potential values are passed on to the electronic unit via the multiplex arrangement, the voltage states of the individual battery cells are determined in the electronic unit to determine the state of charge, wherein the voltage of an individual battery cell is determined by subtracting the potential after the respective battery cell and the potential before the respective battery cell, and the state of charge is displayed.

2. Method according to claim 1, wherein the state of charge indication comprises an optical or acoustic signal.

3. Method according to claim 1 or 2, wherein a measured value processing device is provided downstream of the multiplex arrangement.

4. Method according to claim 3, wherein the measurement value processing device comprises an analog/digital converter and/or a measurement amplifier.

5. Method according to one of the preceding claims, wherein the battery cells are lithium cells.

## Revendications

1. Procédé pour déterminer les tensions des éléments de batterie individuels dans un bloc de batterie d'un outil électrique à main, qui comprend un bo tier de batterie ainsi que des éléments de batterie connectés en série et disposés dans le bo tier de batterie et une unité électronique connectée aux éléments de batterie pour déterminer la tension des éléments de batterie
dans lequel un dispositif de multiplexage est prévu entre les éléments de la batterie et l'unité électronique, les valeurs de tension des éléments de la batterie sont prélevées en continu ou à des moments discrets pendant le processus de charge et de décharge de manière cyclique l'un après l'autre et les valeurs obtenues sont ensuite transmises à l'unité électronique,
dans lequel la tension de chaque élément de batterie individuel ou d'un bloc d'éléments de batterie constitué d'éléments de batterie connectés en parallèle peut être prélevée séparément et dans lequel un affichage de l'état de charge indiquant l'état de charge du bloc de batterie est prévu,
où, pendant le processus de charge et de décharge, le potentiel avant chaque élément de batterie connecté en série et ensuite après le dernier élément de batterie est déterminé cycliquement l'un après l'autre, les valeurs de potentiel sont transmises à l'unité électronique par l'intermédiaire du dispositif de multiplexage, les états de tension des différents éléments de batterie sont déterminés dans l'unité électronique pour déterminer l'état de charge, où la tension d'un élément de batterie individuel est déterminée en soustrayant le potentiel après l'élément de batterie respectif et le potentiel avant l'élément de batterie respectif, et l'état de charge est affiché.

2. Procédé selon la revendication 1, dans laquelle l'indication de l'état de charge comprend un signal optique ou acoustique.

3. Procédé selon la revendication 1 ou 2, dans laquelle un dispositif de traitement des valeurs mesurées est prévu en aval de l'arrangement de multiplexage.

4. Procédé selon la revendication 3, dans lequel le dispositif de traitement des valeurs de mesure comprend un convertisseur analogique/numérique et/ou un amplificateur de mesure.

5. Procédé selon l'une des revendications précédentes, dans laquelle les éléments de la batterie sont des piles au lithium.
